Europäisches Patentamt

European Patent Office

Office européen des brevets

(11) Veröffentlichungsnummer : **0 343 725 B1**

# (12) EUROPÄISCHE PATENTSCHRIFT

(45) Veröffentlichungstag der Patentschrift :
**14.12.94 Patentblatt 94/50**

(21) Anmeldenummer : **89201272.5**

(22) Anmeldetag : **22.05.89**

(51) Int. Cl.⁵ : **H04B 10/00**

(54) **Optischer Sender mit einer Laserdiode.**

(30) Priorität : **26.05.88 DE 3817836**

(43) Veröffentlichungstag der Anmeldung :
**29.11.89 Patentblatt 89/48**

(45) Bekanntmachung des Hinweises auf die
Patenterteilung :
**14.12.94 Patentblatt 94/50**

(84) Benannte Vertragsstaaten :
**DE FR GB**

(56) Entgegenhaltungen :
**DE-A- 2 847 182**
**DE-A- 2 902 789**
**DE-A- 3 508 034**
**US-A- 4 305 047**

(73) Patentinhaber : **Philips Patentverwaltung**
**GmbH**
**Wendenstrasse 35c**
**D-20097 Hamburg (DE)**
㊽ **DE**
Patentinhaber : **N.V. Philips'**
**Gloeilampenfabrieken**
**Groenewoudseweg 1**
**NL-5621 BA Eindhoven (NL)**
㊽ **FR GB**

(72) Erfinder : **Grünziger, Rupert, Dipl.-Ing. (FH)**
**Michael-Glossner-Strasse 34**
**D-8430 Neumarkt (DE)**

(74) Vertreter : **Peuckert, Hermann, Dipl.-Ing. et al**
**Philips Patentverwaltung GmbH,**
**Wendenstrasse 35c**
**D-20097 Hamburg (DE)**

EP 0 343 725 B1

**Beschreibung**

Die Erfindung betrifft einen optischen Sender mit einer Laserdiode und einer an sie optisch gekoppelten Fotodiode als Monitordiode, deren Fotostrom zur Regelung der Lichtleistung der Laserdiode verwendet wird, mit Modulatoren zur Modulation des Laserdiodenstromes mit einem Nutzsignal und einem Pilotsignal.

Ein optischer Sender mit diesen Merkmalen ist in der DE 31 37 497 A1 beschrieben. Zweck derartiger optischer Sender ist es unter anderem, das von der Laserdiode ausgehende und über Glasfasern übertragene Lichtsignal in möglichst allen Kenngrößen zeitlich konstant zu halten. Diese Kenngrößen können sich z.B. durch Änderung der Umweltbedingungen oder aufgrund der Alterung der Laserdiode verändern. Die Laserdiode ist derjenige Baustein, der Alterungsprozessen am stärksten unterworfen ist, wogegen alle anderen zur Zeit auf dem Markt erhältlichen Bausteine in Zeiträumen vergleichbar mit 10 bis 15 Jahren keine nennenswerten Veränderungen erfahren.

Die Alterungsprozesse ändern z.B. die Kennlinie der Laserdiode (Abhängigkeit der abgegebenen Lichtleistung P vom Laserdiodenstrom IL). Die Kennlinie besteht vereinfacht gesehen aus zwei Geradenstücken, einem flachen, durch den Nullpunkt gehenden Stück und einem sich anschließenden steileren Geradenstück, in dessen Bereich im Betriebsfall der Diodenstrom liegen muß.

Der gemeinsame Punkt der beiden Geradenstücke, der Knickpunkt der Kennlinie, darf im Betriebsfall vom Laserdiodenstrom nicht unterschritten werden, weil sonst Verzerrungen im Lichtsignal des Lasers auftreten. Daher muß der Laserdiodenvorstrom Iv mindestens so groß sein wie der dem Knickpunkt entsprechende Schwellenstrom IO. Verändert sich die Lage des Knickpunktes durch Alterungsprozesse, so muß auch der Laserdiodenvorstrom verändert werden, damit die oben erwähnten Verzerrungen nicht im Lichtsignal auftreten.

Ändert sich hingegen die Steigung (Steilheit) des zweiten Geradenstückes in der Laserdiodenkennlinie, so verändert das die mittlere abgegebene Leistung der Laserdiode. Da auch diese Kenngröße konstant gehalten werden soll, muß auch der dem Vorstrom überlagerte Anteil des Laserdiodenstromes - der sogenannte Modulationsstrom - nachgeregelt werden.

Die tatsächlichen Veränderungen der Laserdiodenkennlinie bestehen aus einer Überlagerung beider Anteile, nämlich der Verschiebung des Knickpunktes und der Verkleinerung der Steilheit. Genau diese Überlagerung macht das Problem bei der Regelung der Sendeleistung eines optischen Senders aus, da nur die Summenwirkung ohne weiteres bestimmbar ist, jedoch nicht die Wirkung der einzelnen Summanden.

Bei der bekannten Anordnung enthält der Modulationsstrom zwei Regelsignale gleicher Frequenz und unterschiedlicher Amplitude, die gegeneinander um 180° phasenverschoben sind. Das eine Regelsignal beeinflußt den Modulationsstrom an der Obergrenze und das andere an der Untergrenze. Der gesamte Laserdiodenstrom ist wirkungsgleich zu einem Laserdiodenstrom, dessen Vorstrom sich mit der Frequenz der Regelsignale ändert, wie sich anhand der weiter unten abgeleiteten Formeln zeigen läßt.

Ein solcher zeitabhängiger Vorstrom bringt mindestens zwei Nachteile mit sich:

1. Das Lichtsignal wird mit Jitter behaftet, da die zeitliche Flankenlage der Lichtimpulse davon abhängt, von welchem Vorstromwert an der Laserdiodenstrom ansteigt.

2. Stromschwankungen in der Umgebung des Schwellenstromes der Laserdiode bringen andere Lichtfrequenzen in das abgestrahlte Laserlicht, so daß das optische Emissionsspektrum verbreitert wird. Das führt wegen der Dispersion des Übertragungsmediums zu einer zusätzlichen Verzerrung des übertragenen Lichtsignales.

Der Erfindung liegt die Aufgabe zugrunde, einen optischen Sender der eingangs genannten Art anzugeben, bei dem der oben genannte Jitter und die oben genannten Verzerrungen vermieden werden.

Diese Aufgabe wird gelöst durch:

1.1. Mittel zur Multiplikation eines Steuerstromes mit dem Nutzsignal, wobei der Steuerstrom ein mit dem Pilotsignal modulierter Gleichstrom ist,

1.2. Filtermittel, mit denen die Amplitude derjenigen Komponente des Fotostromes isoliert wird, deren Frequenz mit der Grundfrequenz des Pilotsignales übereinstimmt, und Mittel zur Regelung der Amplitude des Wechselanteiles des Steuerstromes, derart, daß die erwähnte Komponente im Fotostrom der Monitordiode konstant bleibt,

1.3. Mittel, mit denen das Verhältnis der Amplitude des Wechselanteiles zum Gleichanteil des Steuerstromes konstant gehalten wird, und

1.4. Filtermittel, mit denen der Gleichanteil des Fotostromes der Monitordiode bestimmt wird, und Mittel zur Regelung des Vorstromes der Laserdiode derart, daß auch der Gleichanteil des Fotostromes konstant bleibt.

Die erfindungsgemäße Lösung erlaubt eine Schaltungstechnik, in der weniger Hochfrequenz-Transistoren verwendet werden können als bei vergleichbaren Schaltungen nach dem Stand der Technik.

Ist das Pilotsignal Informationsträger, so kann die mit diesem Signal verbundene Nachricht durch in der Glasfaser reflektiertes Licht gestört werden. Fällt das reflektierte Licht auf die Laserdiode, so verändert das ihren Schwellenstrom, also die Untergrenze des Modulationsstromes. Da erfindungsgemäß der Modulationsstrom nur an der Obergrenze durch das Pilotsignal beeinflußt wird, können mit dem Pilotsignal verbundene Nachrichten nicht durch die Schwellenstromänderungen gestört werden.

Durch das Konstanthalten des Modulationsgrades des Steuerstromes kann für den Fall, daß mit dem Pilotsignal eine Nachricht übertragen wird, diese Nachricht immer ohne weiteres detektiert werden.

Anhand der Figuren soll ein Ausführungsbeispiel der Erfindung näher erläutert werden.

Es zeigen:

Fig. 1 eine Laserdiodenkennlinie mit Zeitdiagrammen einiger Anteile des Laserdiodenstromes und

Fig. 2 das Prinzipschaltbild eines optischen Senders mit erfindungsgemäßen Merkmalen.

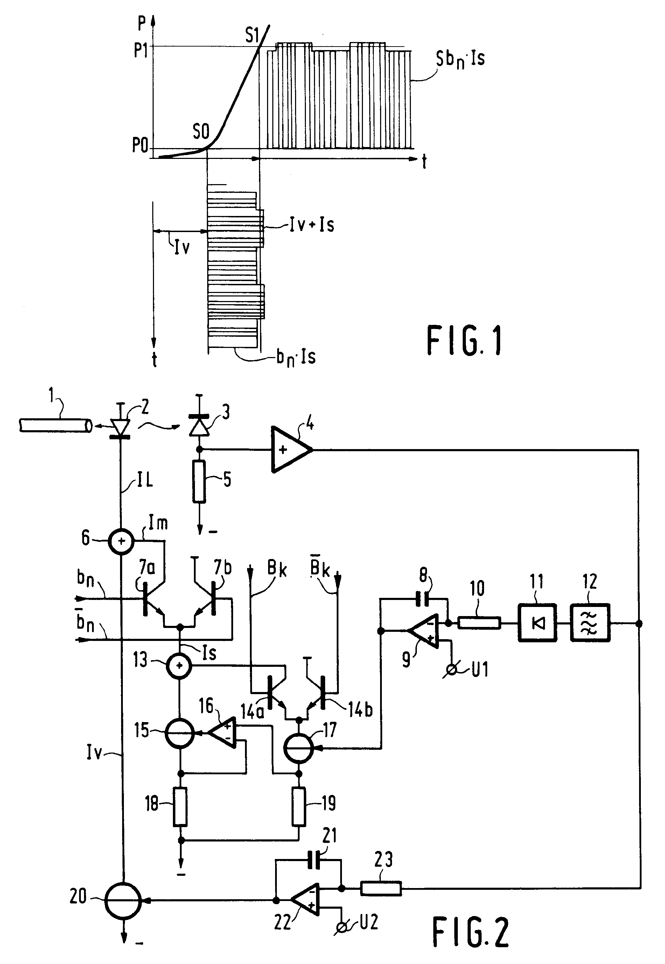

Im Zusammenhang mit der Erläuterung der Fig. 1 sollen auch grundsätzliche Überlegungen dargestellt werden, an denen erkennbar ist, wie eine Schaltung mit erfindungsgemäßen Merkmalen die gestellte Aufgabe löst. In allen nun folgenden Ausführungen wird angenommen, daß das Nutzsignal und das Pilotsignal binäre Signale sind.

Der obere Teil der Fig. 1 zeigt eine Laserdiodenkennlinie, bei der die abgestrahlte Leistung P der Laserdiode gegen den Laserstrom IL aufgetragen ist. Im Knickpunkt SO der Kennlinie gibt die Laserdiode die Leistung PO ab, wenn durch sie ein Strom fließt, der so groß wie der Schwellenstrom IO der Laserdiode ist. Im gezeigten Fall ist der Vorstrom Iv gerade dem Schwellenstrom IO gewählt. Der Vorstrom Iv ist der minimale Laserdiodenstrom. Der maximale Laserdiodenstrom besteht aus der Summe des Vorstromes Iv und dem Maximum des Modulationsstromes Im. Im Maximum des Modulationsstromes liegt die abgestrahlte Lichtleistung der Laserdiode bei P1 am Punkt S1 der Kennlinie. Genauer gilt für den Laserdiodenstrom IL

$$IL = Iv + Im = Iv + b_n * Is \quad (1)$$

Dabei ist $b_n$ das n-te Bit (0 oder 1) des zu übertragenden Binärsignales, dessen Bitfolgefrequenz im GHz-Bereich liegt. Der Strom Is ist ein Steuerstrom, der selbst wieder mit der Frequenz eines sogenannten Pilotsignales moduliert ist. Die Bitfolgefrequenz des Pilotsignales liegt im kHz-Bereich. Der Steuerstrom Is läßt sich eindeutig in einen Gleichanteil Ig und einen Wechselanteil Iw zerlegen, so daß gilt:

$$Is = Ig + Iw = Ig + (1 - 2*B_k)*A$$
$$= Ig*(1 + (1 - 2*B_k)*m. \quad (2)$$

Der Gleichanteil Ig ist der zeitliche Mittelwert (bzw. der nullte Fourier-Koeffizient) des Steuerstromes Is. Der Wechselanteil Iw - dessen Mittelwert null ist - läßt sich in der oben angegebenen Form darstellen, wobei A die Amplitude des Wechselanteiles Iw ist und $B_k$ das k-te Bit (0 oder 1) des Pilotsignales bedeutet. Die Darstellung unter Verwendung des Modulationsgrades m = A/Ig des Steuerstromes Is soll im folgenden bevorzugt werden. Die hier genannten Mittelungen haben über Zeiten zu erfolgen, die groß gegen die Bitdauer des Pilotsignales sind.

Mit dem bisherigen Abkürzungen ergibt sich für den gesamten Laserdiodenstrom IL:

$$IL = Iv + b_n*Ig*(1 + (1 - 2*B_k)*m). \quad (3)$$

Entsprechend diesem Strom gilt für die abgestrahlte momentane Lichtleistung P der Laserdiode

$$P = PO + b_n*S*Ig*(1 + (1 - 2*B_k)*m), \quad (4)$$

mit S als Steilheit der Laserdiode. Hieraus bestimmt sich die mittlere abgestrahlte Leistung zu

$$\underline{P} = PO + \frac{S*Ig}{2}, \quad (5)$$

wobei wiederum über Zeiten gemittelt worden ist, die groß gegen die Dauer eines Bits des Pilotsignales sind. Zur Begründung des für die mittlere abgestrahlte Leistung $\underline{P}$ erhaltenen Ausdruckes sei darauf hingewiesen, daß sich als Mittelwert der Bits $b_n$ der Wert ½ ergibt, ebenso als Mittelwert der Bits $B_k$. Das Mittel der Produkte der Bits $b_n*B_k$ ist wegen der unterschiedlichen Bitdauer gleich dem Produkt der Mittelwerte. Werden nämlich die Bits $b_n$ über die Dauer eines Bits $B_k$ gemittelt, so ergibt sich schon dann der Wert ½, weil die Mittelung über etwa $10^6$ Bits $b_n$ erfolgt, während die Bits $B_k$ von dieser Mittelung nicht betroffen sind.

Die mittlere Lichtleistung $\underline{P}$ soll unter der Nebenbedingung konstant gehalten werden, daß der Vorstrom Iv der Laserdiode nicht unter den Schwellenstrom Is fällt. Wie Gleichung 5 zeigt, kann sich die Leistung $\underline{P}$ wegen einer Änderung von S und wegen einer Änderung von PO ändern. Die Änderung von PO geht mit einer Änderung des Knickpunktes der Kennlinie bzw. mit einer Änderung des Schwellenstromes IO einher.

Nun wird ein Teil der Lichtleistung von einer Monitordiode in einen Fotostrom Ip umgesetzt. Es gilt

$$Ip = K*(PO + b_n*S*Ig*(1 + (1 - 2*B_k)*m), \quad (6)$$

wobei K eine Konstante ist, die die Kopplung der Laserdiode an die Monitordiode sowie den Wirkungsgrad der Monitordiode zum Ausdruck bringt. Wichtig ist, daß die Konstante K sich nicht mit zunehmendem Betriebsalter der Anordnung ändert.

Der Fotostrom Ip wird jetzt - das ist mit Filtermitteln möglich - in zwei Bestandteile zerlegt. Der erste Bestandteil ist sein Gleichanteil Ipg; er ergibt sich durch Mittelung über Zeiten, die groß gegen die Dauer der Bits $B_k$ sind, zu:

$$Ipg = K*(PO + \frac{S*Ig)}{2}. \quad (7)$$

Der zweite Anteil ist ein Wechselanteil Ipw und stellt denjenigen Anteil des Fotostromes dar, der sich mit der Frequenz des Pilotsignales ändert. Man erhält ihn, wenn man den Fotostrom zunächst über Zeiten mittelt, die kleiner als die Dauer eines Bits $B_k$ jedoch groß gegen die Dauer eines Bits $b_n$ sind, und dann von diesem gemittelten Wert den Wechselanteil bestimmt. Er ergibt sich zu:

$$Ipw = \frac{K*S*Ig*m*}{2}(1 - 2*B_k). \quad (8)$$

Die Amplitude dieses Wechselanteiles ist

$$Apw = \frac{m*K*Ig*S}{2}. \quad (9)$$

Mit Apw wird erfindungsgemäß der Steuerstrom Is geregelt und mit Ipg der Laserdiodenvorstrom Iv, wobei folgende Umstände zu berücksichtigen sind:

1. Der Modulationsgrad m des Steuerstromes Is wird durch eine Schaltung konstant gehalten, d.h., m bleibt zum Beispiel vom Betriebsalter der Anordnung unabhängig.

2. Bei Inbetriebnahme des optischen Senders sind alle Kenngrößen des Laserdiodenstromes IL so eingestellt, daß die Anforderungen an einen ordnungsgemäßen Betrieb erfüllt sind, Apw und Ipg haben also bestimmte Anfangswerte. Wird nun Ig so gesteuert, daß Apw immer auf seinem Anfangswert bleibt, so verändert sich der zweite Term in der Gleichung 5 für die mittlere Leistung $\underline{P}$ nicht, denn es folgt aus Gleichung 9:

$$S*Ig = \frac{2*Apw}{m*K}, \quad (10)$$

wobei auf der rechten Seite nur konstante Werte stehen.

3. Wegen der Regelung von Apw auf seinen Anfangswert bleibt auch der zweite Term des Stromes Ipg in Gleichung 7 konstant, so daß eine Änderung von Ipg nur auf eine Änderung von PO zurückzuführen ist. Wird nun Ipg durch Änderung des Vorstromes Iv auf seinem Anfangswert gehalten, so wird auch PO auf seinem Anfangswert gehalten. Das ist jedoch nur dadurch möglich, daß die Regelschaltung die Werte des Vorstromes Iv automatisch immer so einstellt, daß er (geringfügig) über dem Schwellenstrom IO liegt oder ihm gleicht.

Bei der in Fig. 2 dargestellten Schaltungsanordnung werden die zu übertragenden Lichtsignale in einen Lichtwellenleiter 1 eingespeist. Die Lichtsignale werden von einer Laserdiode 2 erzeugt. Ein Teil des von der Laserdiode 2 abgestrahlten Lichtes fällt auf eine Fotodiode 3 als Monitordiode. Der Fotostrom Ip der Monitordiode wird über einen Widerstand 5 in eine proportionale Spannung umgewandelt und durch einen Verstärker 4 verstärkt.

Das Ausgangssignal des Verstärkers 4 wird einem Bandpaß 12 sowie einer ersten Regeleinrichtung 21, 22, 23, U2 zugeführt. Die erste Regeleinrichtung 21, 22, 23, U2, bestehend aus einem Operationsverstärker 22, der über einen Kondensator 21 gegengekoppelt ist und einen Eingangswiderstand 23 aufweist, bestimmt den Gleichanteil im Ausgangssignal des Verstärkers 4, der zum Gleichanteil Ipg (vgl. Gleichung 7) des Fotostromes proportional ist. Dieser Anteil wird mit einer Spannung U2 verglichen, die bei Inbetriebnahme des Senders eingestellt wird. Das Ausgangssignal der ersten Regeleinrichtung dient als Stellgröße für eine steuerbare Stromquelle 20, die den Vorstrom Iv (vergleiche Formel 1) für die Laserdiode 2 liefert.

Die Parameter des Bandpasses 12 sind so gewählt, daß durch ihn die Komponente im Ausgangssignal des Verstärkers 4 herausgefiltert wird, deren Frequenz mit der Grundfrequenz, des Pilotsignales übereinstimmt. Das Ausgangssignal des Bandpasses 12 durchläuft einen Vollweggleichrichter 11, dessen Ausgangssignal proportional ist zur Amplitude Apw (vergleiche Formel 9) der durch den Bandpaß 12 herausgefilterten Komponente. Diese Amplitude wird durch eine zweite Regeleinrichtung 8, 9, 10, U1 mit Hilfe einer Vergleichsspannung U1 ebenfalls auf einem Wert gehalten, der bei Inbetriebnahme des optischen Senders eingestellt wird.

Das Ausgangssignal der zweiten Regeleinrichtung liefert die Stellgröße für eine weitere steuerbare Stromquelle 17, deren Stromstärke bis auf einen Faktor mit der Amplitude A des Wechselanteiles des Steuerstromes Is (vergleiche Formel 2) übereinstimmt. Diese Amplitude wird so geregelt, daß die Ausgangsspannung des Vollweggleichrichters 11 mit der Spannung U1 übereinstimmt.

Der Strom der Stromquelle 17 wird vom Differenzverstärker 14a, 14b mit den Bits des Pilotsignales multipliziert, denn der Transistor 14a bzw. 14b wird von den Bits $B_k$ bzw. invertierten Bits $\overline{B}_k$ des Pilotsignales angesteuert. An einem Summationspunkt 13 wird der modulierte Strom der Stromquelle 17 mit dem Gleichstrom einer weiteren steuerbaren Stromquelle 15 überlagert. Das Ergebnis der Überlagerung ist der Steuerstrom Is nach Formel 2.

Durch einen Vergleicher 16, dessen Ausgangssignal die Stromquelle 15 steuert, und Widerstände 18, 19, die von den Strömen der Stromquellen 15 und 17 durchflossen werden, wird der Modulationsgrad des Steuerstromes Is festgelegt und zeitlich konstant gehalten.

Über einen weiteren Differenzverstärker 7a, 7b wird nun der Steuerstrom Is mit den Bits des Nutzsignales multipliziert. Die Bits $b_n$ werden der Basis des Transistors 7a zugeführt, während der Transistor 7b mit den invertierten Bits $\overline{b}_n$ angesteuert wird. Das Ergebnis der Multiplikation ist der Modulationsstrom Im (vgl. Formel 1), der an einem zweiten Summationspunkt 6 zum Gleichstrom Iv der Stromquelle 20 hinzuaddiert wird. Der Summenstrom ist der Laserdiodenstrom IL nach Formel 3.

**Patentansprüche**

1. Optischer Sender mit einer Laserdiode (2) und eine an sie optisch gekoppelte Fotodiode (3) als Monitordiode, deren Fotostrom zur Regelung der Lichtleistung der Laserdiode (2) verwendet wird, mit Modulatoren zur Modulation des Laserdiodenstromes (IL) mit einem Nutzsignal ($b_n$) und einem Pilotsignal ($B_k$), gekennzeichnet durch fol-

gende Merkmale:

1.1. Mittel zur Multiplikation (7a, 7b) eines Steuerstromes (Is) mit dem Nutzsignal (b$_n$), wobei der Steuerstrom (Is) ein mit dem Pilotsignal (B$_k$) modulierter Gleichstrom ist,

1.2. Filtermittel (11, 12), mit denen die Amplitude derjenigen Komponente des Fotostromes isoliert wird, deren Frequenz mit der Grundfrequenz des Pilotsignales (B$_k$) übereinstimmt, und Mittel (8, 9, 10, U1, 17) zur Regelung der Amplitude des Wechselanteiles des Steuerstromes (Is), derart, daß die Amplitude der erwähnten Komponente im Fotostrom der Monitordiode (3) konstant bleibt,

1.3. Mittel (16, 18, 19) mit denen der Grad der Modulation des Steuerstromes (Is) mit dem Pilotsignal (B$_K$) konstant gehalten wird, und

1.4. Filtermittel (21), mit denen der Gleichanteil des Fotostromes der Monitordiode bestimmt wird, und Mittel (21, 22, U2, 23, 20) zur Regelung des Vorstromes (Iv) der Laserdiode (2) derart, daß auch der Gleichanteil des Fotostromes konstant bleibt.

## Claims

1. Optical transmitter comprising a laser diode (2) and, coupled to the laser diode, a photodiode (3) operating as a monitor diode, whose photoelectric current is used for adjusting the light power of the laser diode (2), and including modulators used for modulating the laser diode current (IL) by a useful signal (b$_n$) and a pilot signal (B$_k$), characterized by the following features:

1.1 Means to multiply (7a, 7b) a control current (Is) by the useful signal (b$_n$), the control current (Is) being a d.c. current modulated by the pilot signal (B$_k$),

1.2 Filter means (11, 12), isolating the amplitude of the component of the photoelectric current, whose frequency corresponds to the fundamental frequency of the pilot signal (B$_k$), and means *8, 9, 10, U1, 17) to adjust the amplitude of the a.c. component of the control current (Is) in a manner so that the amplitude of above component of the photoelectric current of the monitor diode (3) remains constant,

1.3 Means (16, 18, 19) by which the degree of modulation of the control current (Is) is maintained constant by the pilot signal (B$_k$), and

1.4 Filter means (21), determining the d.c. component of the photoelectric current of the monitor diode, and means (21, 22, U2, 23, 20) to adjust the bias current (Iv) of the laser diode (2) in a manner so that also the d.c. component of the photoelectric current remains constant.

## Revendications

1. 1. Emetteur optique comportant une diode laser (2) et une photodiode (3) couplée optiquement à celle-ci à titre de diode de contrôle, dont le courant photoélectrique est utilisé pour la régulation de la puissance lumineuse de la diode laser (2), avec des modulateurs pour moduler le courant (IL) de la diode laser par un signal utile (b$_n$) et un signal pilote (B$_k$), caractérisé par les particularités suivantes :

1.1. un moyen de multiplication (7a, 7b) d'un courant de commande (Is) par le signal utile (b$_n$), le courant de commande (Is) étant un courant continu modulé par le signal pilote (B$_k$);

1.2. un moyen de filtrage (11, 12) qui permet d'isoler l'amplitude de la composante du courant photoélectrique, dont la fréquence coïncide avec la fréquence fondamentale du signal pilote (B$_k$), et un moyen (8, 9, 10, U1, 17) permettant de régler l'amplitude de la fraction alternative du courant de commande (Is), de telle sorte que la composante mentionnée reste constante dans le courant photoélectrique de la diode de contrôle (3);

1.3. un moyen (16, 18, 19) qui permet de maintenir constant le degré de la modulation du courant de commande (Is) avec le signal pilote (B$_k$), et

1.4. un moyen de filtrage (21) qui permet de déterminer la fraction continue du courant photoélectrique de la diode de contrôle, et un moyen (21, 22, U2, 23, 20) pour la régulation du courant de polarisation (Iv) de la diode laser (2), de telle sorte que la fraction continue du courant photoélectrique reste également constante.

FIG.1

FIG.2